Europäisches Patentamt

European Patent Office

Office européen des brevets

(19)

(11) EP 0 874 465 A1

(12) EUROPEAN PATENT APPLICATION

(43) Date of publication:
28.10.1998 Bulletin 1998/44

(51) Int Cl.6: H03M 7/40

(21) Application number: 98302109.8

(22) Date of filing: 20.03.1998

(84) Designated Contracting States:
AT BE CH DE DK ES FI FR GB GR IE IT LI LU MC NL PT SE
Designated Extension States:
AL LT LV MK RO SI

(30) Priority: 21.04.1997 GB 9707985

(71) Applicant: RACAL COMMUNICATIONS SYSTEMS LIMITED
Bracknell, Berkshire RG12 1RG (GB)

(72) Inventor: Whitehouse, Steven John
Witney, Oxfordshire OX8 6NU (GB)

(74) Representative: Bibby, William Mark et al
Mathisen, Macara & co.
The Coach House
6-8 Swakeleys Road
Ickenham Uxbridge UB10 8BZ (GB)

(54) Error resilient variable length code

(57) An error resilient processing technique includes storing encoded data consisting of variable length codewords in different data blocks forming different respective storage slots. If the encoded data does not completely fill the storage slot to which the data has been allocated overflow data is stored in the slot. In one aspect of the invention the storage capacity of each slot is a multiple of n-bits, where n is a fixed integer greater than unity. In another aspect of the invention different components of the encoded data are stored with reference to opposite ends of the slot. Thus, error propagation is prevented by allowing a resynchronization with the beginning of a variable length codeword at the beginning or at the end of each storage slot.

Fig.1

## Description

This invention relates to error resilient processing techniques. Such techniques find particular, though not exclusive, application in the compression, and associated decompression of digital image data, for example digital image data that is to be transmitted via a communications link.

Hitherto, various image compression techniques have been used to reduce the amount of image data that needs to be stored prior to transmission via a communications link. One disadvantage of these techniques is that any error introduced into the compressed image data as a result of the processing can have a magnified effect when the data is eventually decompressed; indeed, a single bit error could, in some situations, prevent decoding of an entire image frame.

Error correcting codes have been proposed with a view to improving the effective bit error rate. However, error correcting codes often involve a substantial overhead in the data transmission channel, and this reduces the advantage gained by compression.

Error resilient techniques, such as the known Error Resilient Entropy Code (EREC) technique have also been proposed. These techniques seek to limit the effect of any errors rather than eliminate the errors altogether, and have the advantage that they involve minimal overhead, but rely on careful ordering of the encoded data. Nevertheless, notwithstanding these advantages, there is a general requirement to refine the existing error resilient techniques with a view to improving their effectiveness.

With this objective in mind, one aspect of the present invention provides an error resilient method for processing a plurality of data blocks, each comprising encoded data which has been encoded using one or more prefix codes, the method including the steps of storing the encoded data of each said data block in a different respective storage slot, and, if said encoded data does not completely fill that storage slot, storing therein overflow data that has overflowed from one or more than one of the other storage slots, and in which the storage capacity of each storage slot is a multiple of n-bits, where n is a fixed integer greater than unity.

The storage slots may not all have the same storage capacity.

As will be explained in greater detail hereinafter, this method is advantageous in that it enables the stored data to be read from the storage slots in units of n-bits, thereby considerably reducing the processing time on a given architecture needed for this operation.

As is well known, prefix codes have the characteristic that no codeword is identical to, and therefore confusable with the start of any other codeword.

The encoded data of each data block forms an overall prefix code.

The encoded data may be entropy-encoded data generated, for example, using Huffman coding or Arithmetic coding. In the case of Huffman coding, the entropy-encoded data comprises a Huffman prefix code representing the length of the data being encoded together with the data itself, which follows the prefix code. In the case of Arithmetic coding the data is encoded directly.

In many implementations, particularly, though not exclusively, for processing image data, the encoded data of each said data block comprises a set of encoded frequency coefficients.

In a preferred implementation of the invention, said overflow data is placed in a storage slot with reference to a pseudo-randomly generated offset.

There is also provided a method for decoding encoded data that has been stored in accordance with the error resilient method according to said first aspect of the invention, the decoding method including the steps of reading at least some of the encoded data stored in the storage slots in units of n-bits, where n is said fixed integer and decoding the encoded data that has been read.

According to a second aspect of the invention there is provided an error resilient method for processing a plurality of data blocks, each comprising encoded data which has been encoded using one or more prefix codes, the encoded data being separable into a first component and a second component, the method including the steps of storing encoded data of each said data block in a different respective storage slot having a first end and a second end, the first and second components of the encoded data being stored with reference to said first and second ends respectively, the first component starting at said first end and progressively filling the slot in a first direction approaching said second end, and the second component starting at said second end and progressively filling the slot in a second direction approaching said first end, and if said encoded data does not completely fill the storage slot, storing therein overflow data that has overflowed one or more than one of the other storage slots.

Because each storage slot has two starting points for the stored data, compared with the single starting point used conventionally, the resilience to errors is improved.

The encoded data of each data block forms an overall prefix code.

The encoded data may be entropy-encoded data generated, for example, using Huffman coding or Arithmetic coding. In the case of Huffman coding, the entropy-encoded data comprises a Huffman prefix code representing the length of the data being encoded together with the data itself, which follows the prefix code. In the case of Arithmetic coding the data is encoded directly.

In many implementations, particularly, though not exclusively, for processing image data, the encoded data of each said data block comprises a set of encoded frequency coefficients. In this case, said first component is a d.c. component of the encoded data and said second component is an a.c. component of the encoded data.

In a preferred embodiment, overflow-data received from successive ones of said other storage slots is preferably stored with reference to said first and second ends alternately, the overflow data adding to the data that has already been stored in the slot with reference to the first and second ends respectively. Said overflow data is preferably placed in a storage slot with reference to a pseudo-randomly generated offset.

In one embodiment of this aspect of the invention, the storage capacity of each storage slot is a multiple of n bits, where n is a fixed integer greater than unity.

There is also provided a method for decoding encoded data that has been stored in accordance with the error resilient method of said second aspect of the invention, the decoding method including the steps of alternately reading encoded data stored in the storage slots with reference to their first and second ends, and decoding the encoded data that has been read.

The methods defined in accordance with the first and second aspects of the invention find particular, though not exclusive, application in methods and systems for compressing and decompressing digital image data.

Thus, according to a yet further aspect of the invention there is provided a method for compressing digital image data representing an image frame consisting of a plurality of image blocks, the method comprising the steps of, transforming the image data corresponding to each said image block to generate a respective set of frequency coefficients for that block, deriving from at least some of said sets of frequency coefficients respective data blocks, each comprising a corresponding set of encoded frequency coefficients encoded using one or more prefix codes, and subjecting said data blocks to an error resilient method according to said first and/or said second aspect of the invention.

In a preferred embodiment, the image data is transformed using the Hierarchical Modified Fast Lapped Transform (HMFLT) and each said data block contains a set of Huffman codes and a corresponding set of frequency coefficients.

According to another aspect of the invention, there is provided a system for compressing digital image data representing an image frame consisting of a plurality of image blocks, the system comprising means for transforming the image data corresponding to each said image block to generate a respective set of frequency coefficients for that block, encoding means for deriving from at least some of said sets of frequency coefficients respective data blocks, each comprising a corresponding set of encoded frequency coefficients encoded using one or more prefix codes, and means for subjecting said data blocks to an error resilient method according to said first and/or said second aspects of the invention.

Preferably the transformation means is a Hierarchical Modified Fast Lapped Transform (HMFLT) transformation means and said encoding means derives for each said data block a set of Huffman codes and a corresponding set of frequency coefficients.

The invention also provides a decompression method and system corresponding to said compression method and system respectively.

An embodiment of the invention is now described, by way of example only, with reference to the accompanying drawings of which:

Figure 1 shows an encoder using a modified EREC process according to the invention;

Figures 2a to 2c illustrate the conventional EREC process;

Figures 3a and 3b illustrate a single storage slot in the conventional and modified EREC processes respectively, and

Figure 4 shows a decoder for decoding encoded data produced by the encoder of Figure 1.

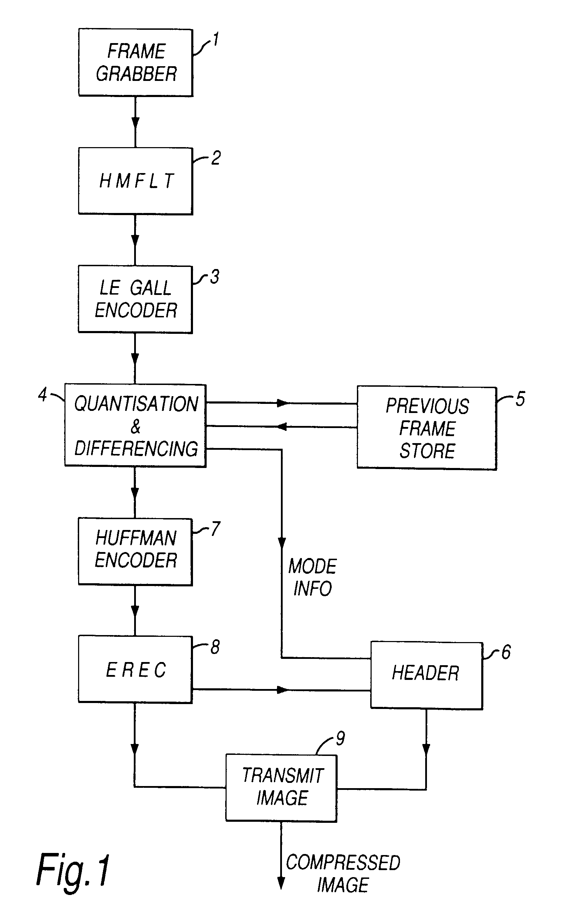

Referring to Figure 1, the encoder comprises a frame grabbing unit 1 which grabs the next frame of digital image data and stores this data in the encoder frame store (not shown). Each frame is notionally divided up into a plurality of overlapping image blocks which are all the same size, typically 8 x 8 pixels, and each such block undergoes an initial compression stage in an HMFLT unit 2 and a Le Gall filter unit 3.

The HMFLT unit 2 subjects the image data in each image block to the known Hierarchical Modified Fast Lapped Transform (HMFLT). In effect, the HMFLT decorrelates the spatial information in the image block; more specifically, it transforms the image data in the block to the frequency domain to produce a set of frequency coefficients. Many of the higher frequency coefficients will be zero or near zero and are relatively unimportant in terms of image reproduction. Therefore, these coefficients are not required, enabling a substantial degree of compression to be achieved.

The frequency coefficients produced by the HMFLT will exhibit some built-in redundancy due to the correlation between adjacent image blocks. This redundancy is reduced by the Le Gall filter unit 3 which subjects the coefficients to so-called wavelet filtering. In effect, the Le Gall filter unit 3 filters the low frequency coefficients in both the longitudinal and horizontal directions.

It will be appreciated that a different transform, such as the Discrete Cosine Transform (DCT) or the Lapped Orthogonal Transform (LOT) could alternatively be used; however, these transforms are not as effective as the HMFLT used in combination with Le Gall wavelet filtering.

The frequency coefficients thus generated are subjected to a further compression stage in a quantisation and differencing unit 4.

Initially, the frequency coefficients are quantised to remove those coefficients which are relatively unimportant in terms of image quality. To this end, each frequency coefficient is divided by an integer constant, and if the resultant value is less than a near-zero threshold value that frequency coefficient will be treated as zero. The image quality achieved in this way will depend on the integer constant used; the larger the constant, the lower the image quality.

The quantised frequency coefficients derived for each image block are then compared with the frequency coefficients which were derived from the equivalent image block in the immediately preceding frame and which are stored in a frame storage unit 5.

The frequency coefficients for the current image block are then treated in one of three modes depending on the result of this comparison.

If the compared coefficients are very different, the coefficients from the current frame are retained for further processing, without any modification, (this is known as the intra mode). If the compared coefficients are only slightly different, the differences between the compared coefficients are used (the inter-mode), resulting in further compression. If the compared coefficients are identical, the coefficients from the current frame will not be used (the inactive mode), resulting in even greater compression. Clearly, information about the mode used for each image block needs to be retained to enable subsequent decoding, and this information is stored in a header unit 6.

It will be understood that the differencing operation could, if desired, be omitted, and the frequency coefficients in all the image blocks would then be retained for further processing.

Following the quantization and differencing process there will have been generated a plurality of different sets of frequency coefficients, each set corresponding to a respective image block in the current frame. The first coefficient in a set will be the d.c. coefficient and the other coefficients will be a.c. coefficients, although some of these corresponding to the higher frequencies are likely to be zero.

Each set of frequency coefficients then undergoes entropy-encoding in Huffman encoder unit 7. To this end, each coefficient in the set is ascribed a Huffman prefix code which signifies the length of the coefficient. The Huffman prefix codes are variable-length codes so designed as to minimize the total length of the data transmitted and this is achieved by assigning the codes so that those with a higher probability of being transmitted are the shortest. The first coefficient to be encoded is the d.c. coefficient, and this coefficient is encoded as a Huffman code which encodes the length of the coefficient followed by the coefficient itself. The subsequent a.c. coefficients are similarly encoded as respective pairs of Huffman codes and coefficients; however, the a.c. Huffman codes also encode the length of any run of zeros preceding the coefficient which is being encoded. As a result of this process, each set of frequency coefficients is encoded to produce a respective data block containing a set of entropy-encoded frequency coefficients, of which the first coefficient is the d.c. coefficient and the remaining coefficients are a.c. coefficients.

The data blocks generated in this way are next subjected to error resilient processing to reduce the effect of any errors introduced into the data as a consequence of earlier processing.

The error resilient processing technique used is a modified form of the conventional Error Resilient Entropy Code (EREC) process, and is applied to the data blocks by EREC unit 8.

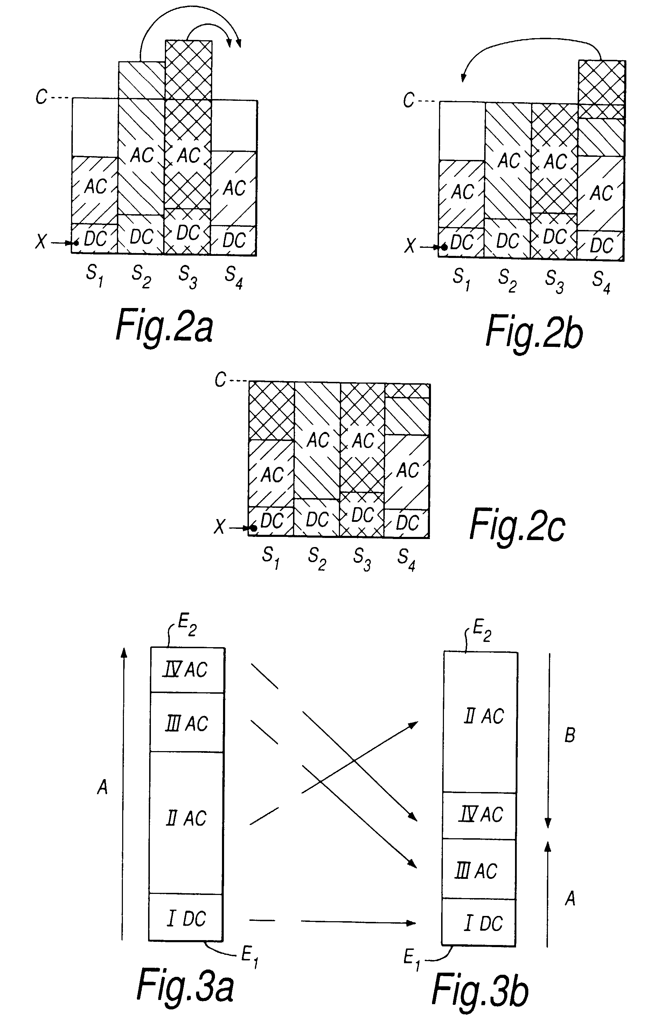

To assist in an understanding of the modified process, the conventional EREC process will be described first with reference to Figures 2a to 2c.

Each data block is allocated to a respective storage slot. For clarity of illustration, only four such slots are shown in Figures 2a to 2c, and these are referenced $S_1$, $S_2$, $S_3$, $S_4$. The slots all have the same storage capacity which is an average taken over all the data blocks that are to be processed. More specifically, the storage capacity C of each storage slot is given by the expression, $C = \frac{T}{N}$, where N is the number of data blocks and T is the total number of bits contained in the data blocks.

As shown in Figures 2a to 2c, the d.c. coefficient of a data block is stored in the respective storage slot first, followed by the a.c. coefficients for that data block.

The data blocks will, of course, have a range of different sizes and so, although some of the data blocks will only partially fill their respective storage slots (slots $S_1$ and $S_4$ in Figure 2a), others of the data blocks will overflow their respective storage slots (slots $S_2$ and $S_3$ in Figure 2a). In subsequent stages of the process, the overflow data is transferred to partially filled storage slots until all the data has been placed.

Thus, referring to Figures 2a and 2b, the additional bits which have overflowed storage slot $S_2$ are placed into the first available, partially filled storage slot, $S_4$ and the additional bits which have overflowed storage slot $S_3$ are also transferred to storage slot $S_4$, but they will not all fit. As shown in Figures 2b and 2c, the surplus is placed in storage slot $S_1$, thereby completing the process.

The storage slot to which overflow data is transferred is determined by an offset calculated from a pseudo-random sequence. The same pseudo-random sequence is also used during decoding. This enables overflow data read from a storage slot to be distributed to the respective data block from which that data was derived, so that the entropy-encoded frequency data contained in the data blocks can be decoded.

Each storage slot has a distinct starting point defined by the end of the previous slot. Therefore, the data stored in each slot is entirely independent of the data stored in all the other slots. Accordingly, if an error should arise in one of the slots, the data in the other slots will be preserved intact. However, the conventional EREC process has the drawback that if an error should occur close to the start of the slot (e.g. at position X in slot $S_1$), all the subsequent data stored in that slot will be lost, including any overflow data from other slots. The modified EREC process of the invention aims to alleviate this shortcoming of the conventional process, and is now described with reference to Figures 3a and 3b.

Figure 3a shows, in somewhat greater detail, how data is stored in a storage slot according to the conventional EREC process, and Figure 3b shows how that same data would be stored according to the modified process. Referring to Figure 3a, the stored data starts at end $E_1$ of the storage slot and progressively fills the slot in the direction of arrow A, i.e. the direction approaching the opposite end $E_2$.

The first data to be stored in the slot is the d.c. coefficient of the respective data block allocated to that slot, and this data occupies region I closest to end $E_1$. The a.c. coefficients of the data block are then stored in region II, which follows on immediately from region I, and overflow data from two other slots occupies regions III and IV respectively to complete the filling of the slot.

Referring now to Figure 3b, the modified EREC process differs significantly from the conventional EREC process in that it adopts a bi-directional approach; that is, the modified process uses two starting points, one at each end of the slot, relative to which the data is stored. As before the d.c. coefficient of the allocated data block is stored in region I at end $E_1$ of the slot. This data starts at end $E_1$ and progressively fills the slot in the direction of arrow A, the direction approaching the opposite end, $E_2$ of the slot.

In contrast, the a.c. coefficient of the allocated data block is stored in region II at the opposite end $E_2$ of the slot. This data starts at end $E_2$ and progressively fills the slot in the direction of arrow B, i.e. the direction approaching end $E_1$.

The overflow data from the two other slots then continues the filling procedure alternately in the directions of arrows A and B, such that overflow data from the first of the other slots is stored in region III to form a continuation of the data stored in region I, and the overflow data from the second of the other slots is stored in region IV to form a continuation of the data stored in region II.

The use of two starting points for the stored data, instead of the conventionally used single starting point, has the effect of improving the error resilience of the stored data.

If, for example, an error arises in region I, which had end $E_1$ as its starting point, this error will not affect the a.c. coefficients stored in region II, which had end $E_2$ as its starting point; if the conventional EREC had been used, the data in region II would have been lost.

In another aspect of the invention, it is found to be advantageous to set the storage capacity of the storage slots at a multiple of n bits, where n is a fixed integer greater than unity.

In this case, the storage capacities of the slots are adjusted so that the storage capacity of each slot is a multiple of the integer value n and the average storage capacity of the slots is equal to or greater than, but as close as possible to the above-described average value C. Therefore, the storage slots may not all have the same storage capacity.

The value of the fixed integer n will depend upon the architecture upon which the EREC codec is to be implemented. For example, in the case of the Texas TMS320c50 DSP the value of n might be 16, the word size of the device, and in the case of a desktop PC the value of n might be 8, 16 or 32.

With this approach, data can be read from the storage slots in units of n and this increases the processing speed on a given hardware implementation. Conventionally, bits are read out singly, and a test is performed after each bit has been read to determine whether or not the end of a storage slot has been reached. In contrast, by reading the data in units of n, this test need only be performed after each unit has been read thereby reducing the amount of processing needed. Clearly, the larger the value of n the greater the increase in processing speed.

Furthermore, because each storage slot has a defined starting point, the first variable length Huffman code stored therein will start at the beginning of the first unit of n bits read from the slot and can therefore be decoded using a look-up table without having to shift the data or access more than the first unit of data.

In the case of the modified EREC process, which uses two starting points, the second variable-length Huffman code can also be decoded using a look-up table. However, a problem can arise because the data stored with reference to the opposite ends of the slot will not, in general, meet at the boundary of two units of n bits. In this case, it would be possible to read out most of the data in units of n, and read out the bits singly in the middle section of the slot where the two sections of data meet; however, this approach is unlikely to be very satisfactory if the number of units in each slot is relatively low because it may then be necessary to read a large number of bits singly.

It will be appreciated that the above-described procedure wherein the storage capacity of slots is set at a multiple of an integer number of bits is applicable to any error resilient processing technique in which data is allocated to a plurality of different storage slots; for example, the conventional and modified EREC processes already described.

As a final stage in the encoding process, the encoded data output from the EREC unit 8 is combined with data from the header unit 6 in an output unit 9 from which the encoded data is transmitted.

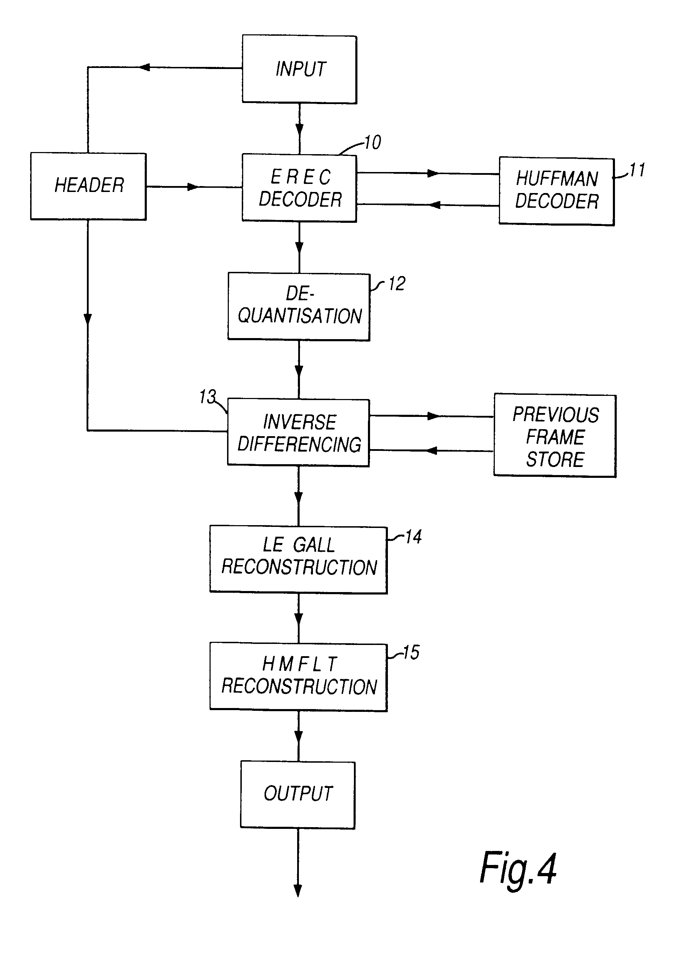

Referring to Figure 4, the decoder, in general terms, carries out the inverse of the operations performed by the encoder. The EREC unit 10 and the Huffman decoder unit 11 operate in close association. The encoded data read out from each storage slot in the EREC unit 10 is decoded in the Huffman decoder unit 11 and immediately scanned for any errors. An error may be flagged either by an invalid Huffman code or a coefficient which exceeds certain predefined thresholds. If an error is detected this may invalidate at least some of the encoded data that is yet to be read out from that storage slot.

The decoded data then undergoes dequantization and inverse differencing in units 12 and 13 respectively and the resultant data is then subjected to an inverse transform in the Le Gall and HMFLT reconstruction units 14,15 in order to reconstruct the original image data.

It is envisaged that the error resilient processing techniques described herein will be of benefit in many applications in which such techniques are used, particularly, though not exclusively, applications in the field of image processing, such as thermal imaging and surveillance.

## Claims

1. An error resilient method for processing a plurality of data blocks, each comprising encoded data which has been encoded using one or more prefix codes, the method including the steps of storing the encoded data of each said data block in a different respective storage slot, and, if said encoded data does not completely fill that storage slot, storing therein overflow data that has overflowed from one or more than one of the other storage slots, and in which the storage capacity of each storage slot is a multiple of n-bits, where n is a fixed integer greater than unity.

2. An error resilient method as claimed in claim 1, wherein the encoded data is entropy-encoded data.

3. An error resilient method as claimed in claim 2, wherein the entropy-encoded data is generated using Huffman coding or Arithmetic coding.

4. An error resilient method as claimed in any one of claims 1 to 3, wherein the encoded data of each said data block comprises a set of encoded frequency coefficients.

5. An error resilient method as claimed in any one of claims 1 to 4, wherein said overflow data is placed in a storage slot with reference to a pseudo-randomly generated offset.

6. A method for decoding encoded data that has been stored in accordance with the error resilient method according to any one of claims 1 to 5, the decoding method including the steps of reading at least some of the encoded data stored in the storage slots in units of n-bits, where n is said fixed integer, and decoding the encoded data that has been read.

7. An error resilient method for processing a plurality of data blocks, each comprising encoded data which has been encoded using one or more prefix codes, the encoded data being separable into a first component and a second component, the method including the steps of storing encoded data of each said data block in a different respective storage slot having a first end and a second end, the first and second components of the encoded data being stored with reference to said first and second end respectively, the first component starting at said first end and progressively filling the slot in a first direction approaching said second end, and the second component starting at said second end and progressively filling the slot in a second direction approaching said first end, and if said encoded data does not completely fill the storage slot, storing therein overflow data that has overflowed one or more than one of the other storage slots.

8. An error resilient method as claimed in claim 7, wherein the encoded data is entropy-encoded data.

9. An error resilient method as claimed in claim 8, wherein the entropy-encoded data is generated using Huffman coding or Arithmetic coding.

10. An error resilient method as claimed in any one of claims 7 to 9, wherein the encoded data of each said data block comprises a set of encoded frequency coefficients.

11. An error resilient method as claimed in claim 10, wherein said first component is a d.c. component of the encoded data and said second component is an a.c. component of the encoded data.

12. An error resilient method as claimed in any one of claims 7 to 11, wherein overflow data received from successive ones of said other storage slots is stored with reference to said first and second ends alternately, the overflow data adding to the data that has already been stored in the slot with reference to the first and second ends respectively.

13. An error resilient method as claimed in any one of claim 7 to 12, wherein said overflow data is placed in a storage slot with reference to a pseudorandomly generated offset.

14. An error resilient method as claimed in any one of claims 7 to 13, wherein the storage capacity of each slot is a multiple of n-bits, where n is a fixed integer greater than unity.

15. A method for decoding encoded data that has been stored in accordance with the error resilient method according to any one of claims 7 to 14, the decoding method including the steps of alternately reading encoded data stored in the storage slots with reference to said first and second ends, and decoding the encoded data that has been read.

16. A method for compressing digital image data representing an image frame consisting of a plurality of image blocks, the method comprising the steps of, transforming the image data corresponding to each said image block to generate a respective set of frequency coefficients for that block, deriving from at least some of said sets of frequency coefficients respective data blocks, each comprising a corresponding set of encoded frequency coefficients encoded using one or more prefix codes, and subjecting said data blocks to an error resilient method according to claims 1 to 5 and/or claims 7 to 14.

17. A method as claimed in claim 16, wherein said image data is transformed using the Hierarchical Modified Fast Lapped Transform (HMFLT).

18. A system for compressing digital image data representing an image frame consisting of a plurality of image blocks, the system comprising means for transforming the image data corresponding to each said image block to generate a respective set of frequency coefficients for that block, encoding means for deriving from at least some of said sets of frequency coefficients respective data blocks, each comprising a corresponding set of encoded frequency coefficients encoded using one or more prefix codes, and means for subjecting said data blocks to an error resilient method according to claims 1 to 5 and/or claims 7 to 14.

19. A system as claimed in claim 18, wherein the transformation means is a Hierarchical Modified Fast Lapped Transform (HMFLT) transformation means.

20. A method and system for decompressing data encoded by the method and system of claims 16 and 18 respectively.

Fig.1

Fig.2a

Fig.2b

Fig.2c

Fig.3a

Fig.3b

*Fig.4*

European Patent Office

**EUROPEAN SEARCH REPORT**

Application Number

EP 98 30 2109

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | REDMILL D W ET AL: "THE EREC: AN ERROR-RESILIENT TECHNIQUE FOR CODING VARIABLE-LENGTH BLOCKS OF DATA" IEEE TRANSACTIONS ON IMAGE PROCESSING, vol. 5, no. 4, 1 April 1996, pages 565-574, XP000582877 * the whole document * | 1-6 | H03M7/40 |
| Y | | 7-20 | |
| Y | US 5 392 037 A (KATO SHIRO) 21 February 1995 * column 31, line 36 - column 33, line 12; figure 7 * | 7-20 | |
| E | WO 97 15888 A (MOTOROLA INC) 1 May 1997 * abstract * * page 7, line 1 - page 8, line 14; figure 1 * | 1,2,5, 7-9,14 | |

TECHNICAL FIELDS SEARCHED (Int.Cl.6)

H03M

The present search report has been drawn up for all claims

| Place of search | Date of completion of the search | Examiner |
|---|---|---|
| MUNICH | 16 July 1998 | Farman, T |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03 82 (P04C01)